# EUROPÄISCHE PATENTANMELDUNG

(11) **EP 4 586 306 A1**
(43) Veröffentlichungstag der Anmeldung: **16.07.2025**
(21) Anmeldenummer: 24151658.2
(22) Anmeldetag: 12.01.2024
(51) Int. Cl.: H01L 21/48, H01L 23/367

(54) **KÜHLKÖRPER FÜR EINE HALBLEITERANORDNUNG, HALBLEITERMODUL, STROMRICHTER UND VERFAHREN ZUR HERSTELLUNG SOLCH EINES KÜHLKÖRPERS**

(71) Anmelder: Siemens Aktiengesellschaft, 80333 München (DE)
(72) Erfinder: Schmenger, Jens, 91301 Forchheim (DE); Kögler, Roman, 90403 Nürnberg (DE); Schwinn, Thomas, 91074 Herzogenaurach (DE)
(74) Vertreter: Siemens Patent Attorneys

(57) **Zusammenfassung**

Es wird ein Kühlkörper für eine Halbleiteranordnung offenbart, wobei der Kühlkörper aus einem ersten metallischen Werkstoff hergestellt ist und der Kühlkörper in mindestens einer Bezugsfläche ein Untermaß aufweist, wobei mittels eines additiven Fertigungsverfahrens die mindestens eine Bezugsfläche des Kühlkörpers erhöht ist.

## Beschreibung

Die Erfindung betrifft einen Kühlkörper für eine Halbleiteranordnung, ein Halbleitermodul mit einer Halbleiteranordnung und solch einem Kühlkörper, einen Stromrichter mit solch einem Halbleitermodul und ein Verfahren zur Herstellung solch eines Kühlkörpers.

Ein typischer Aufbau einer aktuellen Serie von Kühlkörpern erfolgt subtrahierend. Dies bedeutet, dass das Strangpressprofil eines Kühlkörpers mit einem Übermaß gefertigt wird, wobei der Kühlkörper beispielsweise aus Aluminium gefertigt ist. Das Übermaß wird aufgrund von Schwankungen im Fertigungsprozess des Strangpressprofil vorgehalten. Um auf das Sollmaß zu gelangen, wird ein subtrahierendes Verfahren verwendet, beispielsweise ein subtrahierender Fräsvorgang.

Während des Fräsvorgangs werden Bezugsflächen hergestellt, welche für die nachgelagerten Fertigungsvorgänge essenziell sind. Die Kosten des subtrahierenden Prozessschritts werden im Wesentlichen durch den Fräsvorgang und dem Aufmaß des Aluminiums verursacht.

Typische Kühlkörper beinhalten mehrere Funktionalitäten, welche durch die Maßhaltigkeit des Kühlkörper sichergestellt werden müssen. Die Maßhaltigkeit wird in der Konstruktion mit Bezugsflächen und Toleranzen definiert.

Die Bezugsflächen für den Fertigungsprozess und somit die Sicherstellung der Funktionalität im Gerät sind folgend definiert: Beispielsweise ist die Maßhaltigkeit von Seitenflächen des Kühlkörpers notwendig, um das Einschnappen einer Kühlkörperabdeckung sicherzustellen. Ebenfalls werden auf dem Kühlkörper Elemente wie beispielsweise ein DCB-Substrat montiert, die Kontaktflächen auf dem Kühlkörper unterhalb des DCB-Substrats sind mit einer haftvermittelnden Schicht zu veredeln, um eine Lötung des Substrats auf den Kühlkörper zu ermöglichen.

Die Offenlegungsschrift WO 2011/024377 A1 beschreibt ein Halbleitermodul mit einem Wärmestrahlungselement mit einem ersten Element, das Aluminium enthält, und einem zweiten Element, das Kupfer enthält, das in das erste Element eingebettet ist und dessen Seiten von dem ersten Element umschlossen sind; und ein Halbleiterelement, das thermisch mit dem Wärmestrahlungselement verbunden ist.

Es ist Aufgabe der Erfindung, einen alternativen Kühlkörper beziehungsweise ein alternatives Verfahren zur Herstellung solch eines Kühlkörpers anzugeben, bei dem die aufwendigen Schritte eines subtrahierenden Verfahrens vermieden werden.

Die erfindungsgemäße Aufgabe wird durch den Kühlkörper gemäß Patentanspruch 1 gelöst. Vorteilhafte Ausgestaltungen des erfindungsgemäßen Kühlkörpers sind in den Patentansprüchen 2 bis 8 angegeben. Ebenfalls wird die erfindungsgemäße Aufgabe durch das Halbleitermodul gemäß Patentanspruch 9 oder 10 und den Stromrichter gemäß Patentanspruch 11 gelöst. Des Weiteren wird die erfindungsgemäße Aufgabe durch das Verfahren gemäß Patentanspruch 12 gelöst. Vorteilhafte Ausgestaltungen des erfindungsgemäßen Verfahrens sind in den Patentansprüchen 13 und 14 angegeben.

Der erfindungsgemäße Kühlkörper für eine Halbleiteranordnung gemäß Patentanspruch 1 ist aus einem ersten metallischen Werkstoff hergestellt und weist in mindestens einer Bezugsfläche ein Untermaß auf, wobei mittels eines additiven Fertigungsverfahrens die mindestens eine Bezugsfläche des Kühlkörpers erhöht ist.

Vorteilhaft hierbei ist, dass ein aufwendiges und kostenintensives subtrahierendes Verfahren zur Herstellung des Kühlkörpers eingespart wird und nur an den notwendigen Bezugsflächen Erhöhungen vorgenommen werden. Somit kann der erfindungsgemäße Kühlkörper günstiger produziert sein als ein Kühlkörper in Übermaß mit einem anschließenden subtrahierenden Fertigungsverfahren.

In einer Ausgestaltung des erfindungsgemäßen Kühlkörpers hat das additive Fertigungsverfahren Metall auf der mindestens einen Bezugsfläche deponiert. Bei dem additiven Fertigungsverfahren kann schichtweise Aluminium (Al) oder Kupfer (Cu) deponiert worden sein.

In einer weiteren Ausgestaltung des erfindungsgemäßen Kühlkörpers ist das additive Fertigungsverfahren ein Cold-Spray-Verfahren.

In einer Ausgestaltung des erfindungsgemäßen Kühlkörpers deponiert das additive Fertigungsverfahren eine haftvermittelnde Schicht zur Lötung eines zweiten metallischen Werkstoffs.

Bei einer weiteren Ausgestaltung weist die Erhöhung mittels des additiven Fertigungsverfahrens an mindestens einer Bezugsfläche des Kühlkörpers eine Dicke von 15pm bis 2mm auf.

In einer weiteren Ausgestaltung des erfindungsgemäßen Kühlkörpers ist die mindestens eine Bezugsfläche ein Teil der Seitenfläche des Kühlkörpers, wobei dieser Teil als Befestigungspunkt einer Abdeckung für den Kühlkörpers dient.

In einer weiteren Ausgestaltung des erfindungsgemäßen Kühlkörpers ist die mindestens eine Bezugsfläche ein Teil der oberen Fläche des Kühlkörpers, wobei dieser Teil als Befestigungspunkt für ein DCB-Substrat ("Direct Copper Bonding") dient.

Das erfindungsgemäße Halbleitermodul umfasst mindestens eine Halbleiteranordnung und einen erfindungsgemäßen Kühlkörper. Dabei kann die Halbleiteranordnung ein DCB-Substrat ("direct copper bonding") sein.

Der erfindungsgemäße Stromrichter umfasst ein erfindungsgemäßes Halbleitermodul.

Das Verfahren zur Herstellung eines Kühlkörpers umfasst folgende Schritte:
- Bereitstellen eines Kühlkörpers, der aus einem ersten metallischen Werkstoff hergestellt ist und in mindestens einer Bezugsfläche ein Untermaß aufweist;
- Erfassen von mindestens einem Ist-Höhen-Wert der mindestens einen Bezugsfläche;
- Ermitteln von mindestens einem Soll-Höhen-Wert der mindestens einen Bezugsfläche; und
- additives Erhöhen der mindestens einen Bezugsfläche des Kühlkörpers auf den mindestens einen Soll-Höhen-Wert.

In einer Ausgestaltung des erfindungsgemäßen Verfahrens umfasst dies den weiteren Schritt:
- Aufsetzen/Auflöten einer Abdeckung oder eines DCB-Substrats auf die erhöhte mindestens eine Bezugsfläche.

In einer Ausgestaltung des Verfahrens wird das Erfassen von mindestens einem Ist-Höhen-Wert der mindestens einen Bezugsfläche mittels eines Laserscanners durchgeführt.

Die oben beschriebenen Eigenschaften, Merkmale und Vorteile dieser Erfindung, sowie die Art und Weise wie sie erreicht werden, werden klarer und deutlicher verständlich im Zusammenhang mit der Beschreibung der Ausführungsformen, die im Zusammenhang mit den Figuren näher erläutert werden.

Dabei zeigen:
- Figur 1: erfindungsgemäßer Kühlkörper mit Bezugsflächen;
- Figur 2: erfindungsgemäßer Kühlkörper mit Abdeckung und DCB-Substraten;
- Figur 3A und 3B: Kühlkörper in einer Seitenansicht und in einer Aufsicht vor der Anwendung des additiven Fertigungsverfahrens;
- Figur 4: erfindungsgemäßes Verfahren zur Herstellung eines Kühlkörpers;
- Figur 5: Ausgestaltung eines erfindungsgemäßen Verfahrens zur Herstellung eines Kühlkörpers; und
- Figur 6: erfindungsgemäßer Stromrichter.

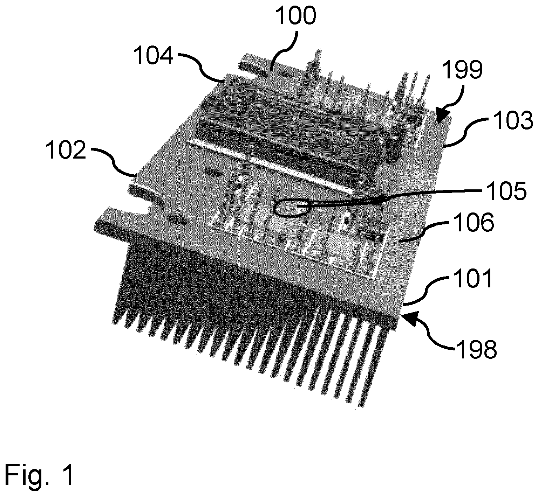

In Figur 1 ist ein erfindungsgemäßer Kühlkörper 100 gezeigt. Der Kühlkörper 100 ist aus einem ersten metallischen Werkstoff hergestellt, beispielsweise Aluminium (Al). Des Weiteren weist der Kühlkörper 100 in mindestens einer Bezugsfläche 101, 102, 103, 104; 105, 105', 105"; 106 ein Untermaß auf. Mittels eines additiven Fertigungsverfahrens ist die mindestens eine Bezugsfläche 101, 102, 103, 104; 105, 105', 105"; 106 des Kühlkörpers 100 erhöht worden.

Entsprechend der Darstellung in Figur 1 kann die mindestens eine Bezugsfläche 101, 102, 103, 104 ein Teil der Seitenfläche 198 des Kühlkörpers 100 sein, wobei dieser Teil als Befestigungspunkt einer Abdeckung 300 für den Kühlkörper 100 dient. Ebenso kann die mindestens eine Bezugsfläche 105, 105', 105"; 106 ein Teil oberen Fläche 199 des Kühlkörpers 100 sein, wobei dieser Teil als Befestigungspunkt für ein DCB-Substrat ("Direct Copper Bonding") dient.

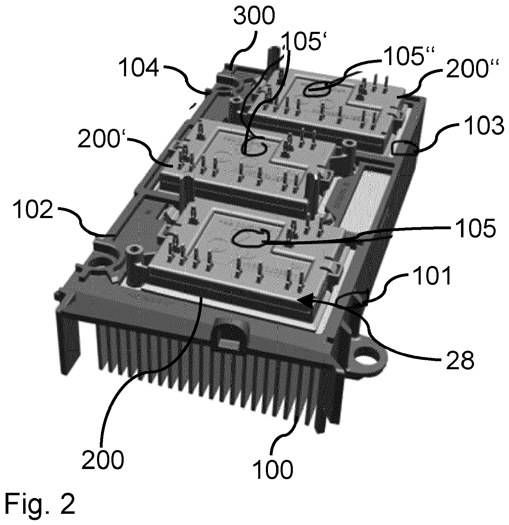

In Figur 2 ist der erfindungsgemäße Kühlkörper 100 für eine Halbleiteranordnung 28 mit einer Abdeckung 300 dargestellt und DCB-Substraten 200, 200', 200".

Die Halbleiteranordnung 28 weist Halbleiterelemente auf, welche als, insbesondere vertikaler, Transistor oder als Diode ausgeführt sind. Ein Transistor kann unter anderem als Insulated-Gate-Bipolar-Transistor (IGBT), als Metalloxide-Semiconductor-Field-Effect-Transistor (MOSFET) oder als Bipolartransistor ausgeführt sein. Einem Transistor kann eine, insbesondere antiparalelle, Diode zugewiesen sein. Die Halbleiterelemente sind stoffschlüssig mit einem Substrat, beispielsweise dem DCB-Substrat 200, 200', 200", verbunden, wobei die stoffschlüssige Verbindung unter anderem durch Löten und/oder Sintern herstellbar ist.

Das additive Fertigungsverfahren kann beispielsweise Metall auf der mindestens einen Bezugsfläche 101, 102, 103, 104; 105, 105', 105"; 106 deponiert haben. Beispielsweise kann das additive Fertigungsverfahren schichtweise Aluminium (Al) oder Kupfer (Cu) deponiert haben. Das additive Fertigungsverfahren kann ein Cold-Spray-Verfahren sein.

Es können in der Pulvermischung auch andere Partikel als Aluminium (Al) oder Kupfer (Cu) enthalten sein, wie beispielsweise Al₂O₃, diese Partikel werden aber nicht in großen Mengen im Verhältnis zum Hauptbestandteil des Pulvers in der Schicht abgeschieden.

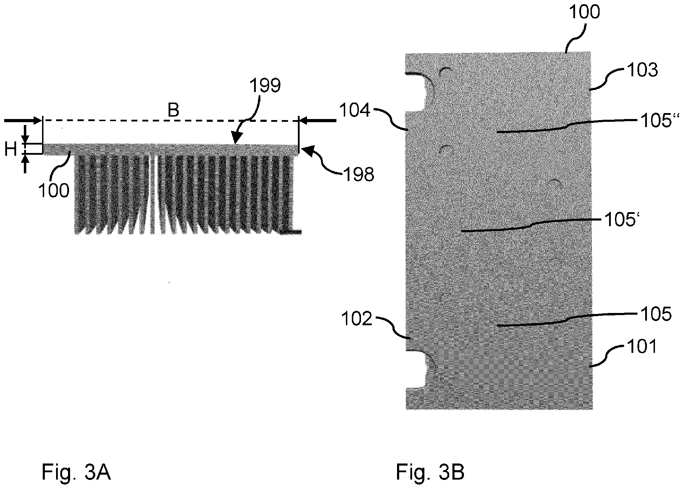

Figur 3A zeigt den erfindungsgemäßen Kühlkörper 100 in einer seitlichen Ansicht, in Figur 3B ist der erfindungsgemäße Kühlkörper 100 in einer Aufsicht dargestellt.

In der seitlichen Ansicht der Figur 3A ergibt sich für den Kühlkörper 100 eine Höhe H und eine Breite B. Um eine Abdeckung 300 mit einer Innen-Breite B' am Kühlkörper 100 anzubringen, muss das Maß des Kühlkörpers 100 exakt eingestellt werden. Durch das additive Auftragen auf den Bezugsflächen 101, 102, 103, 104 auf der Seitenfläche 198 des Kühlkörpers 100 wird die Passgenauigkeit der Abdeckung 300 gewährleistet und die Breite B des Kühlkörpers 100 punktuell an die Innen-Breite B' der Abdeckung 300 angepasst.

Entsprechend der Darstellung der Figur 3B dienen hierfür die Bezugsflächen 101, 102, 103, 104, die sich auf der Seitenfläche 198 des Kühlkörpers 100 befinden.

In Figur 3B sind die Bezugsflächen 105, 105', 105" auf der oberen Fläche 199 des Kühlkörpers 100 eingezeichnet, diese dienen beispielsweise als Befestigungspunkte von DCB-Substraten 200, 200', 200". In diesem Fall soll das additive Fertigungsverfahren eine haftvermittelnde Schicht deponieren, die zur Lötung eines zweiten metallischen Werkstoffs dient. Mittels der Lötung werden beispielsweise DCB-Substrate 200, 200', 200" mit dem erfindungsgemäßen Kühlkörper 100 verbunden.

Die Erhöhung mittels des additiven Fertigungsverfahrens an den Bezugsflächen 101, 102, 103, 104; 105, 105', 105"; 106 des Kühlkörpers 100 können eine Dicke von 15pm bis 2mm aufweisen.

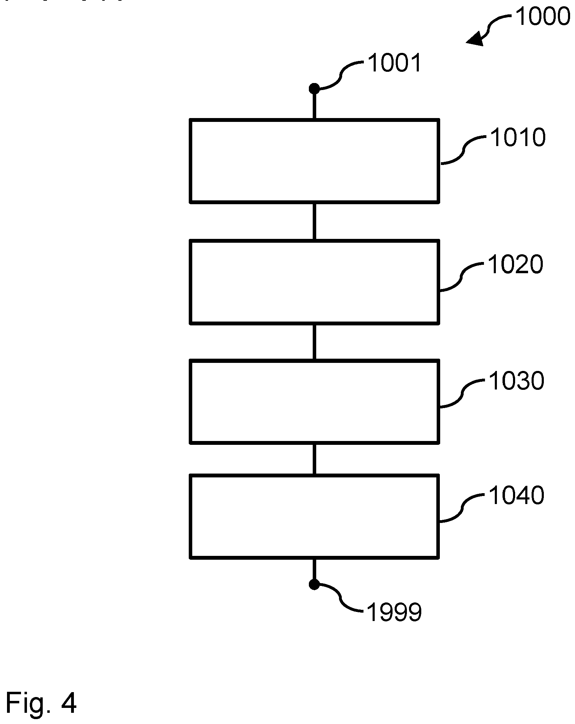

In Figur 4 ist ein erfindungsgemäßes Verfahren 1000 zur Herstellung eines Kühlkörpers 100 dargestellt. Das Verfahren umfasst folgende Schritte zwischen dem Start 1001 und dem Ende 1999:
- Bereitstellen 1010 eines Kühlkörpers 100, der aus einem ersten metallischen Werkstoff hergestellt ist und in mindestens einer Bezugsfläche 101, 102, 103, 104; 105, 105', 105"; 106 ein Untermaß aufweist;
- Erfassen 1020 von mindestens einem Ist-Höhen-Wert der mindestens einen Bezugsfläche 101, 102, 103, 104; 105, 105', 105"; 106;
- Ermitteln 1030 von mindestens einem Soll-Höhen-Wert der mindestens einen Bezugsfläche 101, 102, 103, 104; 105, 105', 105"; 106; und
- additives Erhöhen 1040 der mindestens einen Bezugsfläche 101, 102, 103, 104; 105, 105', 105"; 106 des Kühlkörpers 100 auf den mindestens einen Soll-Höhen-Wert.

Der Soll-Höhen-Wert kann beispielsweise aus der Differenz der Innen-Breite B' einer Abdeckung 300 und der Breite B des bereitgestellten Kühlkörpers 100 ermittelt werden.

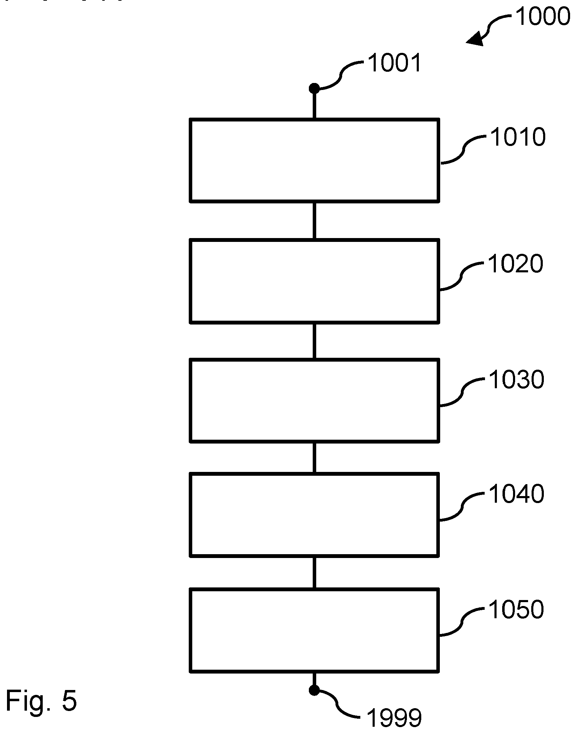

Das erfindungsgemäße Verfahren 1000 kann um einen weiteren Schritt ergänzt werden, wie dies in Figur 5 dargestellt ist:
- Aufsetzen/Auflöten 1050 einer Abdeckung 300 oder eines DCB-Substrats 200, 200', 200" auf die erhöhte mindestens eine Bezugsfläche 101, 102, 103, 104; 105, 105', 105"; 106.

Das Erfassen 1020 des mindestens einen Ist-Höhen-Werts der mindestens einen Bezugsfläche 101, 102, 103, 104; 105, 105', 105''; 106 kann mittels eines Laserscanners durchgeführt werden.

Zum Ermitteln 1030 des mindestens einen Soll-Höhen-Werts der mindestens einen Bezugsfläche 101, 102, 103, 104; 105, 105', 105''; 106 kann jedes übliche Rechen-Verfahren verwendet werden, beispielsweise ein computer-gestütztes Rechen-Verfahren.

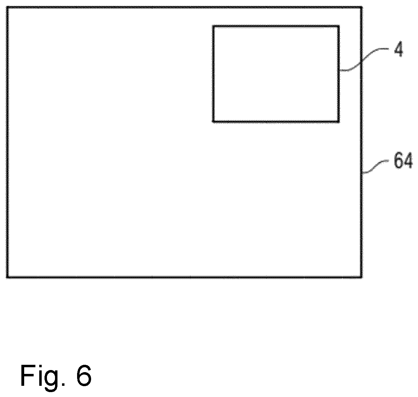

In Figur 6 ist der erfindungsgemäße Stromrichter 64 dargestellt, der ein Halbleitermodul 4 umfasst. Das Halbleitermodul 4 weist dazu eine Halbleiteranordnung 28 und einen erfindungsgemäßen Kühlkörper 100 auf. Beispielsweise kann die Halbleiteranordnung 28 ein DCB-Substrat 200, 200', 200" umfassen.

Das Auftragen der haftvermittelnden Schicht kann ebenso dem Höhenausgleich dienen und eine nachfolgende Lötung ermöglichen.

## Patentansprüche

1. Kühlkörper (100) für eine Halbleiteranordnung (28), wobei der Kühlkörper (100) aus einem ersten metallischen Werkstoff hergestellt ist und der Kühlkörper (100) in mindestens einer Bezugsfläche (101, 102, 103, 104; 105, 105', 105''; 106) ein Untermaß aufweist,
**dadurch gekennzeichnet, dass** mittels eines additiven Fertigungsverfahrens die mindestens eine Bezugsfläche (101, 102, 103, 104; 105, 105', 105''; 106) des Kühlkörpers (100) erhöht ist.

2. Kühlkörper (100) gemäß Patentanspruch 1, bei dem das additive Fertigungsverfahren Metall auf der mindestens einen Bezugsfläche (101, 102, 103, 104; 105, 105', 105"; 106) deponiert hat.

3. Kühlkörper (100) gemäß Patentanspruch 2, bei dem das additive Fertigungsverfahren schichtweise Aluminium (Al) und/oder Kupfer (Cu) deponiert hat.

4. Kühlkörper (100) gemäß einem der vorherigen Patentansprüche, bei dem das additive Fertigungsverfahren ein Cold-Spray-Verfahren ist.

5. Kühlkörper (100) gemäß einem der vorherigen Patentansprüche, bei dem das additives Fertigungsverfahren eine haftvermittelnde Schicht deponiert zur Lötung eines zweiten metallischen Werkstoffs.

6. Kühlkörper (100) gemäß einem der vorherigen Patentansprüche, bei dem die Erhöhung mittels des additiven Fertigungsverfahrens an mindestens einer Bezugsfläche (101, 102, 103, 104; 105, 105', 105"; 106) des Kühlkörpers (100) eine Dicke von 15pm bis 2mm aufweist.

7. Kühlkörper (100) gemäß einem der vorherigen Patentansprüche, bei dem die mindestens eine Bezugsfläche (101, 102, 103, 104) ein Teil der Seitenfläche (198) des Kühlkörpers (100) ist, wobei dieser Teil als Befestigungspunkt einer Abdeckung (300) für den Kühlkörper (100) dient.

8. Kühlkörper (100) gemäß einem der vorherigen Patentansprüche, bei dem die mindestens eine Bezugsfläche (105, 105', 105''; 106) ein Teil der oberen Fläche (199) des Kühlkörpers (100) ist, wobei dieser Teil als Befestigungspunkt für ein DCB-Substrat (200, 200', 200'') ("direct copper bonding") dient.

9. Halbleitermodul (4) mit mindestens einer Halbleiteranordnung (28) und einem Kühlkörper (100) gemäß einem der vorherigen Patentansprüche.

10. Halbleitermodul (4) gemäß Patentanspruch 9, wobei die Halbleiteranordnung (28) ein DCB-Substrat (200, 200', 200") ("direct copper bonding") ist.

11. Stromrichter (64) mit mindestens einem Halbleitermodul (4) gemäß Patentanspruch 9 oder 10.

12. Verfahren (1000) zur Herstellung eines Kühlkörpers (100) umfassend folgende Schritte:
- Bereitstellen (1010) eines Kühlkörpers (100), der aus einem ersten metallischen Werkstoff hergestellt ist und in mindestens einer Bezugsfläche (101, 102, 103, 104; 105, 105', 105"; 106) ein Untermaß aufweist;
- Erfassen (1020) von mindestens einem Ist-Höhen-Wert der mindestens einen Bezugsfläche (101, 102, 103, 104; 105, 105', 105"; 106);
- Ermitteln (1030) von mindestens einem Soll-Höhen-Wert der mindestens einen Bezugsfläche (101, 102, 103, 104; 105, 105', 105"; 106); und
- additives Erhöhen (1040) der mindestens einen Bezugsfläche (101, 102, 103, 104; 105, 105', 105"; 106) des Kühlkörpers (100) auf den mindestens einen Soll-Höhen-Wert.

13. Verfahren (1000) gemäß Patentanspruch 12 mit dem weiteren Schritt:
- Aufsetzen/Auflöten (1050) einer Abdeckung (300) oder eines DCB-Substrats (200, 200', 200") auf die erhöhte mindestens eine Bezugsfläche (101, 102, 103, 104; 105, 105', 105"; 106).

14. Verfahren (1000) gemäß Patentanspruch 12 oder 13, bei dem das Erfassen (1020) von mindestens einem Ist-Höhen-Wert der mindestens einen Bezugsfläche (101, 102, 103, 104; 105, 105', 105''; 106) mittels eines Laserscanners durchgeführt wird.
